Europäisches Patentamt

European Patent Office

Office européen des brevets

(11) Publication number: **0 068 883**
**B1**

## (12) EUROPEAN PATENT SPECIFICATION

(45) Date of publication of patent specification: **10.09.86**

(21) Application number: **82303392.3**

(22) Date of filing: **29.06.82**

(51) Int. Cl.⁴: **H 03 K 19/092, H 03 K 19/094**

(54) A level converter circuit.

(30) Priority: **30.06.81 JP 102875/81**

(43) Date of publication of application:
**05.01.83 Bulletin 83/01**

(45) Publication of the grant of the patent:
**10.09.86 Bulletin 86/37**

(84) Designated Contracting States:
**DE FR GB**

(56) References cited:
**US-A-3 660 676**
**US-A-3 684 897**

**BELL LABORATORIES RECORD, vol. 50, no. 6,
June/July 1972, pages 195-198, Murray Hill
(USA); G.T. CHENEY et al.: "BIGFET makes
IGFET more versatile"**

(73) Proprietor: **FUJITSU LIMITED**
**1015, Kamikodanaka Nakahara-ku
Kawasaki-shi Kanagawa 211 (JP)**

(72) Inventor: **Shimada, Hiroshi
33-3 Kitashinjuku 4-chome Shinjuku-ku
Tokyo 160 (JP)**

(74) Representative: **Sunderland, James Harry et al
HASELTINE LAKE & CO Hazlitt House
28 Southampton Buildings Chancery Lane
London WC2A 1AT (GB)**

Courier Press, Leamington Spa, England.

**Description**

The present invention relates to a level converter circuit, more particularly to a level converter circuit which converts the signal level being output from an integrated circuit (IC) memory device and the like into another arbitrary signal level.

Recently, it is often necessary to couple the output signals of transistor-transistor logic (TTL) or metal oxide semiconductor (MOS) IC's with the input of emitter coupled logic (ECL) ICs or to couple the output signals of ECL ICs with the input of TTL or MOS ICs. For example, the output signals of a random access memory (RAM) consisting of MOS IC's may be coupled with the inputs of a logic circuit consisting of ECL IC's. In such a case, it is necessary to convert the TTL signal level into an ECL signal level. Generally, for the TTL level, ground potential $V_{SS}$ is used as the base potential (reference potential), for example, 0 V, and voltage $V_{CC}$ higher than ground potential by $V_{SS}$ by, for example, 5 V is used as the voltage supply. For the ECL level, ground potential $V_{SS}$ is used as the base potential (reference potential), for example 0 V, and voltage $V_{EE}$ lower than ground potential $V_{SS}$, for example, −5.2 V is used as the voltage supply.

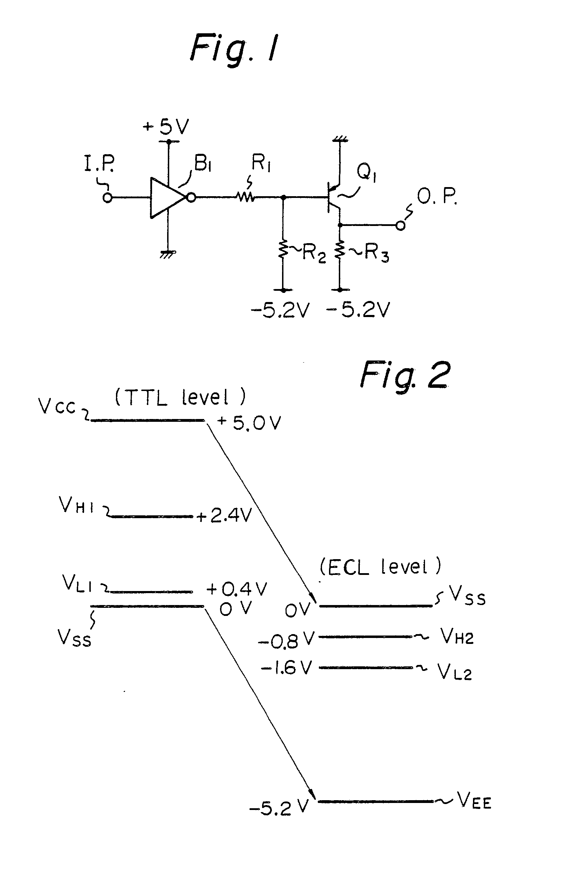

A prior art level converter circuit used for converting TTL level into the ECL level is illustrated in Fig. 1. The level converter circuit of Fig. 1 comprises buffer circuit $B_1$, PNP transistor $Q_1$, and resistors $R_1$, $R_2$, and $R_3$. The operation of the level converter circuit of Fig. 1 is illustrated in Fig. 2. The input signal supplied to the input terminal I.P. of the level converter circuit of Fig. 1 is a TTL level signal in the range between 0 V ($V_{SS}$) and +5.0 V ($V_{CC}$), as shown in Fig. 2. In the TTL level signal, the maximum level of the low (L) level signal is +0.4 V and the minimum level of the high (H) level signal is +2.4 V. The output signal of the level converter circuit of Fig. 1 is an ECL level signal in the range between 0V ($V_{SS}$) and −5.2 V ($V_{EE}$). In the ECL level signal, the maximum level of the L level signal is −1.6V, and the minimum level of the H level signal is −0.8V.

H level signal $V_{H1}$ of the TTL level supplied to input terminal I.P. is converted into H level signal $V_{H2}$ of the ECL level by the level converter circuit. The converter signal is output from output terminal O.P. Similarly, L level signal $V_{L1}$ of the TTL level supplied to input terminal I.P. is converted to L level signal $V_{L2}$ of the ECL level by the level converter circuit. That converted signal is output from output terminal O.P.

As described above, in the level converter circuit of Fig. 1, three voltage supply lines +5.0V, 0 V, and −5.2 V are necessary. However, using three voltage supply lines is disadvantageous for increasing the integration scale of the IC.

U.S. Patent No. 3 684 897 discloses a dynamic MOS memory array timing system in which a dynamic MOS memory array incorporates tapped delay lines for generating refresh pulses. Input signals at TTL levels for the delay lines are converted to ECL levels prior to being applied to the delay lines, by means of buffer elements. Figures 2A and 2B disclose a buffer element comprising six bipolar transistors connected to potential sources of 0, 2, 2.5, 3.1, 3.35 and 5 volts. These include a first bipolar transistor having a collector connected to the 5 volts potential source, and a second bipolar transistor connected between the 5 volts potential source and an out-of-phase output terminal. The base of the second bipolar transistor is connected to an emitter of the first bipolar transistor and to a third bipolar transistor for turning on the second bipolar transistor in response to a first logic signal applied to an input terminal. The third bipolar transistor has an emitter connected to the 0 volts potential source and a collector commonly connected to the base of the second bipolar transistor, the emitter of the first bipolar transistor and the 3.35 volts potential source.

An article in Bell Laboratories Record, Vol. 50, No. 6 June/July 1972 by G.T. Cheney et al, discloses a bipolar — insulated gate FET or BIGFET, being a combination of an insulated gate FET (IGFET) and a npn bipolar transistor in which the collecor of the npn transistor is also the substrate of the IGFET, and a p-type diffusion has the dual role of base for the npn transistor and drain for the IGFET.

As shown in the Figure on page 198 of the article, one disclosed application of the BIGFET is as an output stage of an IGFET integrated circuit.

The circuit diagram representation of the BIGFET output stage shows first and second IGFETs and a bipolar transistor. The first and second IGFETs are connected in series between a positive potential source and ground. The bipolar transistor is connected between the positive potential source and, via a resistor, to ground. The base of the bipolar transistor is connected to the common connection of the first and second IGFETs.

When an input (first IGFET) portion of the BIGFET is conducting, an output (bipolar) portion produces an output potential of approximately 4 volts. When the input portion is turned off, the output potential falls to within a few tenths of a volt. Thus, the BIGFET output stage allows the IGFET integrated circuit to be directly connected to standard buried-collector TTL gates.

An embodiment of the present invention can provide a level converter circuit in which the output signal level of the TTL or MOS Ic being operated between the two voltage supplies is converted into another signal level, the output signal being able to be supplied to the input of another type of IC, for example, an ECL IC.

In accordance with the present invention there is provided a level converter circuit for converting a first logic signal using a lower voltage supply as a reference potential into a second logic signal using a higher voltage supply as a reference potential;

said level converter circuit comprising

an input terminal for receiving the first logic signal;

an output terminal for outputting the second logic signal;

a first bipolar transistor having a collector connected to the higher voltage supply;

a second bipolar transistor connected between the higher voltage supply and the output terminal and having a base connected to an emitter of the first bipolar transistor;

and means for turning on the second bipolar transistor or both bipolar transistors in response to the first logic signal applied to the input terminal, comprising

a first MOS transistor connected in parallel with said first bipolar transistor

and a second MOS transistor connected between the base of the second bipolar transistor and a lower voltage supply ($V_{EE}$), the second MOS transistor having a gate connected to a base of the first bipolar transistor.

BRIEF DESCRIPTION OF THE DRAWINGS

Figure 1 illustrates a circuit diagram of a level converter circuit of a prior art;

Fig. 2 illustrates the level conversion in the circuit of Fig. 1;

Fig. 3 illustrates a circuit diagram of a level converter circuit in accordance with one embodiment of the present invention;

Fig. 4 illustrates a sectional view of a semiconductor substrate on which the circuit of Fig. 3 is formed;

Fig. 5 illustrates a circuit diagram of a typical ECL circuit;

Fig. 6 illustrates the level conversion according to an embodiment of the present invention;

Fig. 7 illustrates a circuit diagram of a level converter circuit in accordance with another embodiment of the present invention; and

Fig. 8 illustrates the sectional view of a semiconductor substrate on which the circuit of Fig. 7 is formed.

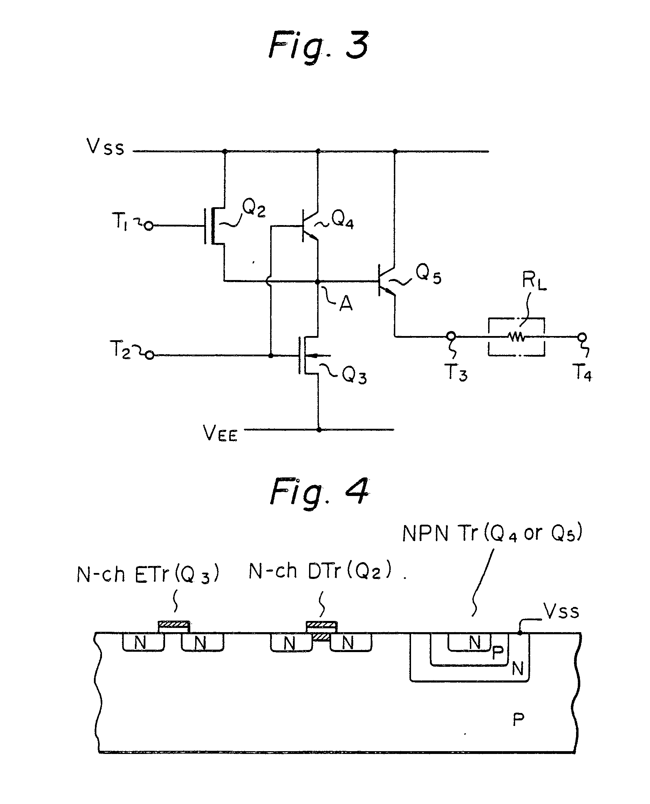

A level converter circuit in accordance with one embodiment of the present invention is illustrated in Fig. 3. The level converter circuit of Fig. 3 comprises depletion type MOS transistor $Q_2$, enhancement type MOS transistor $Q_3$, and NPN-type bipolar transistors $Q_4$ and $Q_5$.

In the level converter circuit of Fig. 3, MOS transistors $Q_2$ and $Q_3$ are connected in series between voltage supply lines $V_{SS}$ and $V_{EE}$. The gates of MOS transistors $Q_2$ and $Q_3$ are connected to input terminals $T_1$ and $T_2$, respectively. Conjunction A between the source of MOS transistor $Q_2$ and the drain of MOS transistor $Q_3$ is also connected to the emitter of bipolar transistor $Q_4$ and the base of bipolar transistor $Q_5$. The collectors of bipolar transistors $Q_4$ and $Q_5$ are both connected to voltage supply line $V_{SS}$. The base of bipolar transistor $Q_4$ is connected to input terminal $T_2$. The emitter of bipolar transistor $Q_5$ is connected to output terminal $T_3$.

Output terminal $T_3$ may be connected to an ECL circuit or another type circuit. In Fig. 3, it is connected to one end of dummy load resistor $R_L$ equivalent to an ECL circuit. The other end of resistor $R_L$ is connected to external voltage supply terminal $T_4$. An arbitrary voltage may be applied

to terminal $T_4$ corresponding to dummy load resistor $R_L$. For example, resistor $R_L$ may be 50 Ω and the voltage applied to the terminal $T_4$ may be −2.0 V with regard to voltage supply $V_{SS}$.

The level converter circuit may be formed on the same IC semiconductor substrate on which a RAM device is formed. Figure 4 illustrates a sectional view of the P-type semiconductor substrate on which MOS transistors $Q_2$, $Q_3$ and bipolar transistor $Q_4$ are formed. As shown in Fig. 4, NPN transistor $Q_4$ is formed in the N-well formed in the P-type substrate.

In the level converter circuit of Fig. 3, higher voltage supply line $V_{SS}$ may be the ground potential, for example, 0 V. The lower voltage supply line $V_{EE}$ may be −5.2 V. Logic signal $S_1$ alternating between $V_{SS}$ and $V_{EE}$ is applied to the input terminal $T_1$. Inverted signal $S_2$ of logic signal $S_1$ is applied to input terminal $T_2$.

Thus, when the "H" level signal ($V_{SS}$) is applied to terminal $T_1$, the "L" level signal ($V_{EE}$) is applied to terminal $T_2$. In this case, MOS transistor $Q_2$ is turned on, and MOS transistor $Q_3$ and bipolar transistor $Q_4$ are turned OFF. Accordingly, the voltage of conjunction A, that is, the base voltage of bipolar transistor $Q_5$, becomes the "H" level ($V_{SS}$) through MOS transistor $Q_2$, and bipolar transistor $Q_5$ is turned ON. Since the emitter of bipolar transistor $Q_5$ is connected to the external voltage supply through dummy load resistor $R_L$, the current flows between the collector and emitter of bipolar transistor $Q_5$. The emitter voltage of bipolar transistor $Q_5$ becomes the value $V_{SS}-V_{BE}$, that is, the voltage lower than the base voltage of bipolar transistor $Q_5$ by base-emitter voltage $V_{BE}$. Thus, the "H" level voltage of the ECL level is obtained at output terminal $T_3$.

Then, when the "L" level signal ($V_{EE}$) is applied to input terminal $T_1$ and the "H" level signal ($V_{SS}$) is applied to input terminal $T_2$, MOS transistor $Q_2$ is turned OFF and MOS transistor $Q_3$ and bipolar transistor $Q_4$ are turned ON. Accordingly, the current flows through bipolar transistor $Q_4$ and MOS transistor $Q_3$, and the emitter voltage of bipolar transistor $Q_4$ becomes lower than voltage $V_{SS}$ of input terminal $T_2$ by base-emitter voltage $V_{BE}$ of bipolar transistor $Q_4$. Since the emitter voltage of bipolar transistor $Q_4$ is applied to the base of bipolar transistor $Q_5$, bipolar transistor $Q_5$ is turned ON, and the emitter voltage of bipolar transistor $Q_5$ becomes lower than the base voltage by base-emitter voltage $V_{BE}$ of bipolar transistor $Q_5$. Thus, the voltage $V_{SS}-2V_{BE}$ is obtained at the output terminal $T_3$. This voltage is used as the "L" level signal of the ECL level.

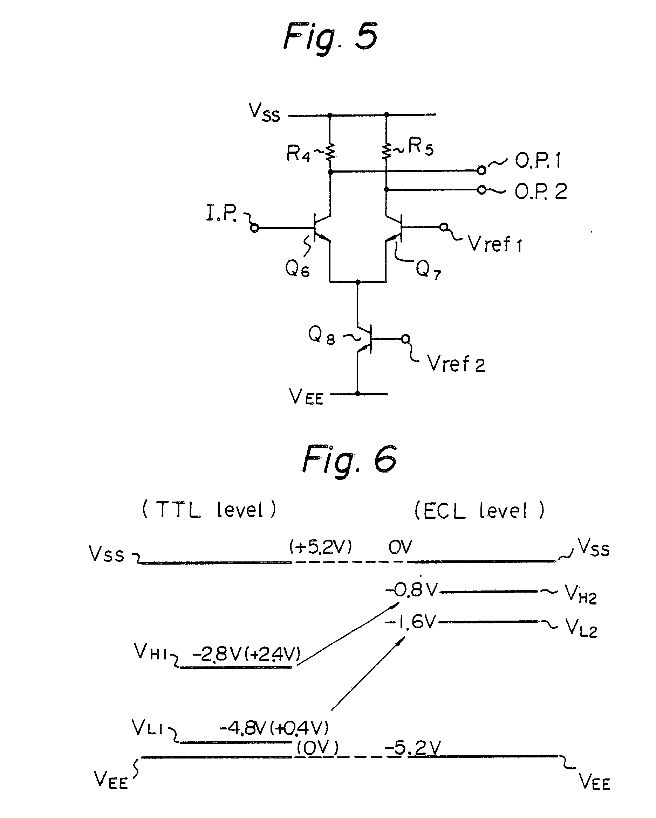

As described above, the output signal of the level converter circuit of Fig. 3 can be directly applied to the input of the typical ECL circuit shown in Fig. 5. The ECL circuit of Fig. 5 comprises NPN type bipolar transistors $Q_6$, $Q_7$, and $Q_8$ and resistors $R_4$ and $R_5$. The level conversion according to the level converter circuit of Fig. 3 is illustrated in Fig. 6.

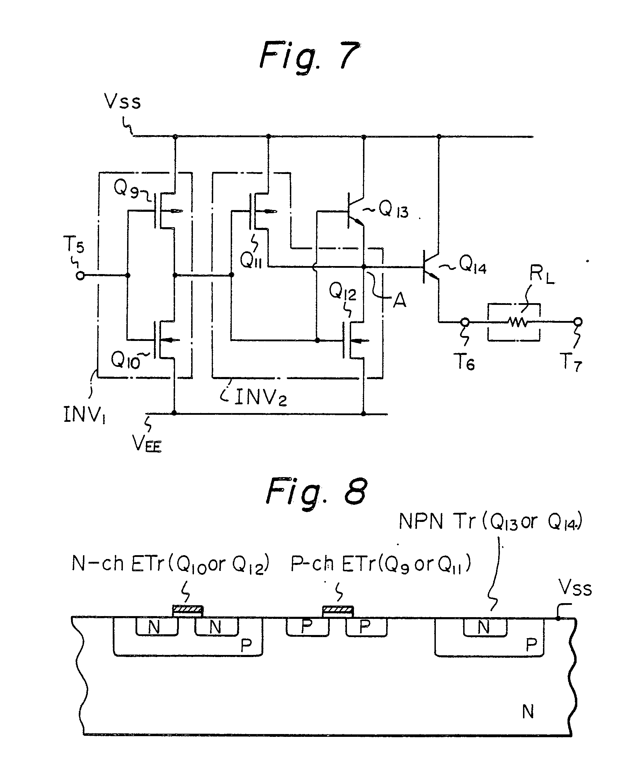

A level converter circuit in accordance with another embodiment of the present invention is illustrated in Fig. 7. The level converter circuit of Fig. 7 comprises P-channel MOS transistors $Q_9$ and $Q_{11}$, N-channel MOS transistors $Q_{10}$ and $Q_{12}$, and NPN type bipolar transistors $Q_{13}$ and $Q_{14}$. The P-channel MOS transistor $Q_9$ and the N-channel MOS transistor $Q_{10}$ are connected in series between higher voltage supply line $V_{SS}$ and lower voltage supply line $V_{EE}$ and form a complementary metal-oxide seminconductor (CMOS) inverter $INV_1$. P-channel MOS transistor $Q_{11}$ and N-channel MOS transistor $Q_{12}$ are also connected in series between voltage supply lines $V_{SS}$ and $V_{EE}$ and form a CMOS inverter $INV_2$. The input of inverter $INV_1$ is connected to input terminal $T_5$, and the output of inverter $INV_1$ is connected to the input of inverter $INV_2$ and to the base of bipolar transistor $Q_{13}$. The collectors of bipolar transistors $Q_{13}$ and $Q_{14}$ are both connected to voltage supply line $V_{SS}$. The emitter of bipolar transistor $Q_{13}$ and the base of bipolar transistor $Q_{14}$ are connected to the output of inverter $INV_2$, that is, the conjunction A between the source of MOS transistor $Q_{11}$ and the drain of MOS transistor $Q_{12}$. The emitter of bipolar transistor $Q_{14}$ is connected to output terminal $T_6$. Output terminal T 12 is connected to external voltage supply terminal $T_7$ through dummy load resistor $R_L$.

The level converter circuit of Fig. 7 may be formed on the N-type semiconductor substrate as illustrated in Fig. 8. On the N-type substrate of Fig. 8, N-channel MOS transistor $Q_{10}$ or $Q_{12}$, P-channel MOS transistor $Q_9$ or $Q_{11}$, and NPN type bipolar transistor $Q_{13}$ or $Q_{14}$ are formed.

In the level converter circuit of Fig. 7, a logic signal is applied to input terminal $T_5$. When the "H" level signal ($V_{SS}$) is applied to input terminal $T_5$, the output signal of inverter $INV_5$ becomes "L" level ($V_{EE}$). Accordingly, P-channel MOS transistor $Q_{11}$ is turned ON, and N-channel MOS transistor $Q_{12}$ and bipolar transistor $Q_{13}$ are turned OFF. Thus, the base voltage of bipolar transistor $Q_{14}$ becomes the $V_{SS}$ level, and the emitter voltage of bipolar transistor $Q_{14}$, that is, the voltage of output terminal $T_6$, becomes the value $V_{SS}-V_{BE}$, just as in the circuit of Fig. 3. When the "L" level signal ($V_{EE}$) is applied to input terminal $T_5$, the output signal of inverter $INV_1$ becomes the "H" level ($V_{SS}$), and, accordingly, P-channel MOS transistor $Q_{11}$ is turned OFF and N-channel MOS transistor $Q_{12}$ and bipolar transistor $Q_{13}$ are turned ON. Thus, the emitter voltage of bipolar transistor $Q_{13}$, that is, the base voltage of bipolar transistor $Q_{14}$, becomes the voltage $V_{SS}-V_{BE}$, and the emitter voltage of bipolar transistor $Q_{14}$, that is the voltage of output terminal $T_6$ becomes the voltage $V_{SS}-2V_{BE}$, just as in the circuit of Fig. 3.

As described above, according to the present invention, there can be provided a level converter circuit which consists of MOS transistors and bipolar transistors formed on the same IC substrate; said level converter circuit converting the MOS level signals obtained from the MOS transistors of the inner circuit into an arbitrary voltage level by means of the bipolar transistors. The level converter circuit according to the present invention has the following advantages

1. The TTL level signals output from the MOS RAM device can be readily converted into ECL signals.

2. It is made possible to couple the ECL logic circuit directly to a RAM or other MOS circuit without using the TTL to ECL converter of a prior art.

3. The integration scale of IC's can be increased.

## Claims

1. A level converter circuit for converting a first logic signal using a lower voltage supply ($V_{SS}$) as a reference potential into a second logic signal using a higher voltage supply ($V_{SS}$) as a reference potential;

said level converter circuit comprising

an input terminal ($T_1$, $T_2$) for receiving the first logic signal;

an output terminal ($T_3$) for outputting the second logic signal;

a first bipolar transistor ($Q_4$) having a collector connected to the higher voltage supply ($V_{SS}$);

a second bipolar transistor ($Q_5$) connected between the higher voltage supply ($V_{SS}$) and the output terminal ($T_3$) and having a base connected to an emitter of the first bipolar transistor ($Q_4$);

and means for turning on the second bipolar transistor ($Q_5$) or both bipolr transistors ($Q_4$, $Q_5$) in response to the first logic signal applied to the input terminal ($T_1$, $T_2$), comprising

a first MOS transistor ($Q_2$) connected in parallel with said first bipolar transistor ($Q_4$)

and a second MOS transistor ($Q_3$) connected between the base of the second bipolar transistor ($Q_5$) and a lower voltage supply ($V_{EE}$), the second MOS transistor ($Q_3$) having a gate connected to a base of the first bipolar transistor ($Q_4$).

2. A level converter circuit according to claim 1, wherein said first MOS transistor ($Q_2$) is a depletion type.

3. A level converter circuit according to claim 1 or 2, wherein said first MOS transistor ($Q_2$) and said second MOS transistor ($Q_3$) form a CMOS inverter.

4. A level converter circuit according to claim 1, 2, or 3, which is incorporated with an output portion of a MOS type random access memory device.

## Patentansprüche

1. Pegelumsetzerschaltung zum Umsetzen eines ersten logischen Signals, welches eine niedrigere Versorgungsspannung ($V_{SS}$) als ein Referenzpotential verwendet, in ein zweites logisches Signal, welches eine höhere Versorgungsspannung ($V_{SS}$) als ein Referenzpotential verwendet;

welche Pegelumsetzerschaltung umfaßt

einen Eingangsanschluß ($T_1$, $T_2$) zum Empfang des ersten logischen Signals;

einen Ausgangsanschluß ($T_3$) zur Ausgabe des zweiten logischen Signals;

einen ersten bipolaren Transistor ($Q_4$), der einen Kollektor hat, der mit der höheren Versorgungsspannung ($V_{SS}$) verbunden ist;

einen zweiten bipolaren Transistor ($Q_5$), der zwischen der höheren Versorgungsspannung ($V_{SS}$) und dem Ausgangsanschluß ($T_3$) angeschlossen ist und eine Basis hat, die it einem Emitter des ersten bipolaren Transistors ($Q_4$) verbunden ist;

und Einrichtungen zum Einschalten des zweiten bipolaren Transistors ($Q_5$); oder beider bipolarer Transistoren ($Q_4$, $Q_5$) in Abhängigkeit von dem ersten logischen Signal, welches dem Eingangsanschluß ($T_1$, $T_2$) zugeführt wird, welche umfassen

einen ersten MOS-Transistor ($Q_2$), der parallel zu dem genannten ersten bipolaren Transistor ($Q_4$) verbunden ist,

und einen zweiten MOS-Transistor ($Q_3$), der zwischen der Basis des zwieten MOS-Transistor ($Q_5$) und einen niedrigeren Versorgungsspannung ($V_{EE}$) verbunden ist, wobei der zweite MOS-Transistor ($Q_3$) ein Gate hat, das mit einer Basis der ersten bipolaren Transistors ($Q_4$) verbunden ist.

2. Pegelumsetzerschaltung nach Anspruch 1, bei welcher der genannte erste MOS-Transistor ($Q_2$) vom Verarmungstyp ist.

3. Pegelumsetzerschaltung nach Anspruch 1 oder 2, bei welcher der genannte erst Transistor ($Q_2$) und der genannte zweite MOS-Transistor ($Q_3$) einen CMOS-Inverter bilden.

4. Pegelumsetzerschaltung nach Anspruch 1, 2 oder 3, die in einem Ausgangsteil einer Speichereinrichtung mit wahlfreiem Zugriff vom MOSS-Typ inkorporiert ist.

**Revendications**

1. Circuit convertisseur de niveau permettant de transformer un premier signal logique, utilisant une alimentation en tension inférieure ($V_{SS}$) comme potentiel de référence, en un deuxième signal logique utilisant une alimentation en tension supérieure ($V_{SS}$) comme potentiel de référence;

ledit circuit convertisseur de niveau comprenant:

— une borne d'entrée ($T_1$, $T_2$) servant à recevoir le premier signal logique;

— une borne de sortie ($T_3$) servant à délivrer le deuxième logique;

— un premiere transistor bijonction ($Q_4$) possédant un collecteur qui est connecté à l'alimentation en tension supérieure ($V_{SS}$);

— une deuxiéme transistor bijonction ($Q_5$) connecté entre l'alimentation en tension supérieure ($V_{SS}$) et la borne de sortie ($T_3$) et présentant une base qui est connectée à l'émetteur du premier transistor bijonction ($Q_4$);

— et un moyen permettant de rendre conducteurs le deuxième transistor bijonction ($Q_5$) ou les deux transistors bijonction ($Q_4$, $Q_5$) en ré- ponse à l'application du premier signal logique à la borne d'entrée ($T_1$, $T_2$), comprenant:

— un premier transistor MOS ($Q_2$) connecté en parallèle ave ledit premier transistor bijonction ($Q_4$),

— et un deuxième transistor MOS ($Q_3$) connecté entre la base du deuxième transistor bijonction ($Q_5$) et une alimentation en tension inférieure ($V_{EE}$), le deuxième transistor MOS ($Q_3$) possédant une grille qui est connectée à la base du premier transistor bijonction ($Q_4$).

2. Circuit convertisseur de niveau selon la revendication 1, où le premier transistor MOS ($Q_2$) est du type appauvrissement.

3. Circuit convertisseur de niveau selon la revendication 1 ou 2, où ledit premier transistor MOS ($Q_2$) et ledit deuxième transistor MOS ($Q_3$) forment un inverseur CMOS.

4. Circuit convertisseur de niveau selon la revendication 1, 2 ou 3, qui est incorporé avec une partie de sortie d'un dispositif de mémoire vive du type MOS.

# Fig. 1

# Fig. 2

## Fig. 3

## Fig. 4

NPN Tr ($Q_4$ or $Q_5$)

N-ch ETr ($Q_3$)    N-ch DTr ($Q_2$)

# Fig. 5

# Fig. 6

(TTL level)       (ECL level)

## Fig. 7

## Fig. 8

NPN Tr (Q13 or Q14)

N-ch ETr (Q10 or Q12)   P-ch ETr (Q9 or Q11)

Vss